(19) Europäisches Patentamt / European Patent Office / Office européen des brevets

(11) **EP 4 395 488 A1**

(12) **EUROPEAN PATENT APPLICATION**
published in accordance with Art. 153(4) EPC

(43) Date of publication:
**03.07.2024 Bulletin 2024/27**

(21) Application number: **22872804.4**

(22) Date of filing: **14.09.2022**

(51) International Patent Classification (IPC):
*H05K 9/00* (2006.01)   *B32B 7/025* (2019.01)
*B32B 25/00* (2006.01)   *B32B 27/18* (2006.01)
*C08L 101/00* (2006.01)   *H01B 3/00* (2006.01)
*H01F 1/113* (2006.01)

(52) Cooperative Patent Classification (CPC):
**B32B 7/025; B32B 25/00; B32B 27/18;**
**C08L 101/00; H01B 3/00; H01F 1/113; H05K 9/00**

(86) International application number:
**PCT/JP2022/034435**

(87) International publication number:
**WO 2023/048050 (30.03.2023 Gazette 2023/13)**

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(30) Priority: **24.09.2021 JP 2021155538**

(71) Applicant: **Maxell, Ltd.**
**Kyoto 618-8525 (JP)**

(72) Inventor: **HIROI, Toshio**
**Kyoto 618-8525 (JP)**

(74) Representative: **Diehl & Partner**
**Patent- und Rechtsanwaltskanzlei mbB**
**Erika-Mann-Straße 9**
**80636 München (DE)**

(54) **ELECTROMAGNETIC WAVE ABSORBER**

(57)   An electromagnetic wave absorber of the present application includes an electromagnetic wave reflection suppression layer and an electromagnetic wave absorption layer, the electromagnetic wave reflection suppression layer contains a first binder, a content ratio of the first binder in the electromagnetic wave reflection suppression layer is 85 mass% or more, the electromagnetic wave absorption layer contains a second binder and an electromagnetic wave absorbing material, and a content ratio of the electromagnetic wave absorbing material in the electromagnetic wave absorption layer is 45 to 85 mass%.

FIG. 1

**Description**

Technical Field

The present application relates to an electromagnetic wave absorber that absorbs electromagnetic waves in the millimeter wave band.

Background Art

With the development of wireless communication technology typified by mobile phones, various devices and sensors are becoming connected to networks wirelessly. Also, in the medical field, from the viewpoint of preventing infection, devices are increasingly becoming cordless, and medical devices are beginning to be connected wirelessly. These communications require high speed and a large capacity over relatively short distances, and use high frequencies. As the number of devices using such high frequencies increases, there is an increasing risk that failure will occur in electronic devices and communication due to malfunction caused by noise generated from the devices or interference with the electromagnetic waves being used. Furthermore, in recent years, millimeter wave radar has begun to be installed for the purpose of preventing automobile collisions. Failure in these devices in the medical and automotive fields has an impact on human life, and therefore malfunctions must not occur. In view of this, it is increasingly necessary to apply electromagnetic wave absorbers to circuit elements and transmission lines that emit and receive electromagnetic waves in the millimeter wave band as a so-called EMC (Electromagnetic Compatibility) countermeasure to prevent failure caused by device noise and interference.

In order to suppress high-frequency noise, conventionally-used electromagnetic wave absorbing sheets that use magnetic loss of a magnetic material have low effectiveness, and resonant electromagnetic wave absorbing sheets that use conductive materials are required (Patent Document 1). However, it is not suitable for the conductive material to directly touch conductive circuit elements or transmission lines, as this causes short-circuiting. Also, even if a case is avoided in which the conductive layer of the resonant electromagnetic wave absorbing sheet directly touches circuit elements or transmission lines by using an adhesive for affixing to the circuit elements or transmission lines, if the sheet is used after being cut or punched to a desired size, the conductive layer will be exposed on the cut surface, and there is a risk of short-circuiting due to contact with this portion. Furthermore, the risk of short-circuiting due to the conductive material falling off cannot be eliminated.

On the other hand, iron oxide magnetic material is a non-conductive material and there is no risk of short-circuiting. In recent years, it has been discovered that epsilon-type iron oxide has the ability to absorb electromagnetic waves in the millimeter wave band, and that the absorption frequency can be controlled by a substitution element and the substitution amount thereof (Patent Documents 2 and 3). Furthermore, hexagonal ferrite is also known to have the ability to absorb electromagnetic waves in the millimeter wave band (Patent Document 4).

Also, Patent Documents 5, 6, and 7 are examples of prior techniques related to the present application. Patent Document 5 discloses a laminated electromagnetic wave absorber whose magnetic permeability and permittivity gradually increase in the direction of transmission of electromagnetic waves from a side on which the electromagnetic waves are incident. Patent Document 6 discloses a radio wave absorber in which the permittivity of a surface layer that functions as a dielectric layer is increased by reducing the amount of a rubber component and increasing the amount of alumina powder contained in the surface layer. Patent Document 7 discloses a radio wave absorber in which a magnetic powder/resin composite in which a magnetic powder is dispersed such that the packing density of the magnetic powder increases continuously along the direction of propagation of radio waves is used, and reflection of radio waves on an incident surface is reduced by arranging a layer made of a low-permittivity material on the incident surface.

Prior Art Documents

Patent Documents

Patent Document 1: JP 2007-81119A (Japanese Patent No. 5481613)
Patent Document 2: JP 2008-60484A (Japanese Patent No. 4787978)
Patent Document 3: JP 2008-277726A (Japanese Patent No. 4859791)
Patent Document 4: JP 2007-250823A (Japanese Patent No. 4674380)
Patent Document 5: JP 2000-31686A
Patent Document 6: JP 2003-133783A
Patent Document 7: JP 2009-188322A

Disclosure of Invention

Problem to be Solved by the Invention

Incidentally, when noise is suppressed by adhering a sheet-shaped electromagnetic wave absorber to an electronic device for which the influence of noise is to be prevented using an adhesive or the like, most of the electromagnetic waves that cause noise are absorbed by the electromagnetic wave absorber and a certain degree of noise suppression effect can be achieved. Also, some of the electromagnetic waves are reflected by the surface of the electromagnetic wave absorber, and the reflected electromagnetic waves reach another electronic device, but there is no problem as long as the electromagnetic wave absorber is adhered to the other electronic device as well.

However, it is difficult in some cases to adhere electromagnetic wave absorbers to all electronic devices, and in such a case, it is also conceivable that electromagnetic waves reflected from the electronic devices to which electromagnetic wave absorbers are adhered will have adverse effects on other unexpected electronic devices.

The present application solves the above problem and provides an electromagnetic wave absorber capable of suppressing electromagnetic waves reflected on its surface.

Means for Solving Problem

The electromagnetic wave absorber of the present application includes an electromagnetic wave reflection suppression layer and an electromagnetic wave absorption layer, the electromagnetic wave reflection suppression layer contains a first binder, a content ratio of the first binder in the electromagnetic wave reflection suppression layer is 85 mass% or more, the electromagnetic wave absorption layer contains a second binder and an electromagnetic wave absorbing material, and a content ratio of the electromagnetic wave absorbing material in the electromagnetic wave absorption layer is 45 to 85 mass%.

Effects of the Invention

According to the present application, it is possible to provide an electromagnetic wave absorber that can suppress reflection of electromagnetic waves incident from the outside on the surface layer, and can absorb electromagnetic waves incident from the surface layer.

Brief Description of the Drawings

[FIG. 1] FIG. 1 is a schematic cross-sectional view showing an example of an electromagnetic wave absorber according to an embodiment of the present application.

[FIG. 2] FIG. 2 is a schematic diagram for illustrating a free space method for measuring an electromagnetic wave reflection attenuation amount and an electromagnetic wave transmission attenuation amount of the electromagnetic wave absorber according to the embodiment of the present application.

Description of the Invention

The electromagnetic wave absorber of the present application includes an electromagnetic wave reflection suppression layer and an electromagnetic wave absorption layer, the electromagnetic wave reflection suppression layer contains a first binder, a content ratio of the first binder in the electromagnetic wave reflection suppression layer is 85 mass% or more, the electromagnetic wave absorption layer contains a second binder and an electromagnetic wave absorbing material, and a content ratio of the electromagnetic wave absorbing material in the electromagnetic wave absorption layer is 45 to 85 mass%.

Since the electromagnetic wave absorber of the present application includes the electromagnetic wave reflection suppression layer and the electromagnetic wave absorption layer and the content ratio of the first binder in the electromagnetic wave reflection suppression layer is higher than the content ratio of the second binder in the electromagnetic wave absorption layer, it is possible to suppress reflection of electromagnetic waves incident from the electromagnetic wave reflection suppression layer side, it is possible to absorb electromagnetic waves incident from the electromagnetic wave reflection suppression layer side, and it is possible to prevent adverse effects of electromagnetic waves on electronic devices overall.

In the electromagnetic wave absorber of the present application, the reason why reflection of electromagnetic waves incident from the electromagnetic wave reflection suppression layer side can be suppressed when the content ratio of the first binder in the electromagnetic wave reflection suppression layer is made larger than the content ratio of the second binder in the electromagnetic wave absorption layer is thought to be as follows.

That is, in general, it is known that the reflectance of an electromagnetic wave absorber increases when the difference between the relative permittivity of the air layer on which electromagnetic waves are incident and the relative permittivity of the surface layer of the electromagnetic wave absorber is large. The relative permittivity of air is about 1, and the relative permittivity of the electromagnetic wave absorption layer of a typical electromagnetic wave absorber is about 10 to 40. On the other hand, the relative permittivity of an electromagnetic wave reflection suppression layer with a large binder content is about 3. Accordingly, by arranging an electromagnetic wave reflection suppression layer with a large binder content between the air layer and the electromagnetic wave absorption layer, the relative permittivity of the electromagnetic wave reflection suppression layer can be brought close to the relative permittivity of air, and the difference between the relative permittivity of the air layer and the relative permittivity of the electromagnetic wave reflection suppression layer becomes smaller. For this reason, it is thought that reflection of electromagnetic waves incident from the electromagnetic wave reflection suppression layer side can be suppressed. Accordingly, the electromagnetic wave reflection suppression layer is preferably disposed on the electromagnetic wave incident side.

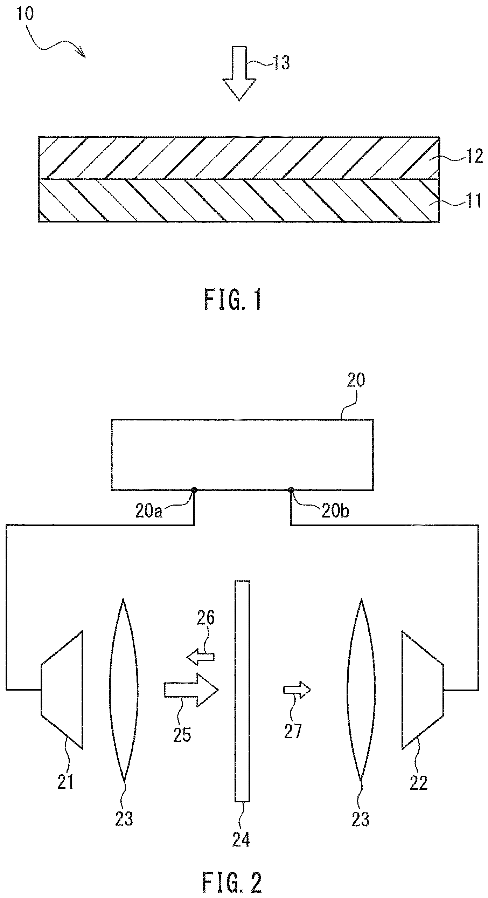

Hereinafter, embodiments of the electromagnetic wave absorber of the present application will be described with reference to the drawings. FIG. 1 is a schematic cross-sectional view showing an example of the electromagnetic wave absorber of this embodiment.

In FIG. 1, an electromagnetic wave absorber 10 of this embodiment includes an electromagnetic wave absorption layer 11 and an electromagnetic wave reflection suppression layer 12. The electromagnetic wave absorber 10 is used with the electromagnetic wave reflection suppression layer 12 disposed on the side where electromagnetic waves 13 are incident. In FIG. 1, the electromagnetic wave absorption layer 11 and the electromagnetic wave reflection suppression layer 12 are directly bonded to each other, but an adhesive layer may also be further disposed between the electromagnetic wave absorption layer 11 and the electromagnetic wave reflection suppression layer 12. This can improve the adhesive strength between both layers.

Also, in FIG. 1, the electromagnetic wave absorber 10 is formed by a two-layer structure of the electromagnetic wave absorption layer 11 and the electromagnetic wave reflection suppression layer 12, but a sticky layer may also be further disposed on the electromagnetic wave absorption layer 11 side. This makes it easy to affix the electromagnetic wave absorber to an electronic device.

Next, each component constituting the electromagnetic wave absorption layer and the electromagnetic wave reflection suppression layer of the electromagnetic wave absorber of this embodiment will be described.

<Electromagnetic Wave Absorbing Material>

The electromagnetic wave absorbing material constituting the electromagnetic wave absorption layer is magnetic iron oxide that has magnetic resonance in a frequency band higher than or equal to the millimeter wave band, and specifically, the following hexagonal ferrite or the following epsilon-type iron oxide can be used. Magnetic iron oxides are usually used in the form of particles.

[Hexagonal Ferrite]

As the above-mentioned hexagonal ferrite, a hexagonal ferrite containing at least one element selected from the group consisting of Sr and Ba and in which some of the Fe sites are substituted with Al can be used. The above-mentioned hexagonal ferrite has a magnetoplumbite-type crystal structure and is represented by the general formula: $AFe_{12}O_{19}$, where A represents at least one element selected from the group consisting of Sr and Ba. The above-mentioned hexagonal ferrite can change the magnetic resonance frequency responsible for electromagnetic wave absorption by substituting some of the Fe sites with a trivalent Al metal element.

Details of the above-described hexagonal ferrite are disclosed in the above-mentioned Patent Document 4 (JP 2007-250823A). Also, it is preferable to use magnetoplumbite-type strontium ferrite as the hexagonal ferrite. By substituting some of the $Fe^{3+}$ in $SrFe_{12}O_{19}$ with $Al^{3+}$, strontium ferrite can have a resonance frequency of 60 GHz to 80 GHz, and an electromagnetic wave absorber compatible with a wireless LAN in the 60 GHz band can be manufactured. Note that by substituting some of the $Fe^{3+}$ with $Al^{3+}$, the frequency that shows electromagnetic wave absorption shifts to the higher frequency side, and it is conceivable that this corresponds to an increase in the value of the anisotropic magnetic field (HA).

[Epsilon-Type Iron Oxide]

As the epsilon-type iron oxide, an epsilon-type iron oxide in which some of the Fe sites are substituted with at least one element selected from the group consisting of Al, Ga, and In can be used. The above-described epsilon-type iron oxide has an ε-phase crystal structure, is represented by the general formula: $\varepsilon\text{-Fe}_2\text{O}_3$, and some of the Fe sites are substituted with at least one element selected from the group consisting of Al, Ga, and In, and thereby the magnetic resonance frequency responsible for electromagnetic wave absorption can be changed.

Details of the epsilon-type iron oxide are disclosed in the aforementioned Patent Document 2 (JP 2008-60484A) and Patent Document 3 (JP 2008-277726A).

<Non-Magnetic Particles>

The electromagnetic wave reflection suppression layer may also contain non-magnetic particles. The non-magnetic particles are added mainly to improve the hardness of the electromagnetic wave reflection suppression layer, and for example, silica particles, talc particles, and the like are used, but other non-magnetic particles may also be used.

<Binder>

The binder included in the electromagnetic wave absorption layer and the electromagnetic wave reflection suppression layer preferably includes at least one type of rubber binder selected from the group consisting of natural rubber (NR), isoprene rubber (IR), butadiene rubber (BR), styrene-butadiene rubber (SBR), butyl rubber (IIR), nitrile rubber (NBR), ethylene-propylene rubber (EPDM), chloroprene rubber (CR), acrylic rubber (ACM), chlorosulfonated polyethylene rubber (CSR), urethane rubber (PUR), silicone rubber (Q), fluororubber (FKM), ethylene-vinyl acetate rubber (EVA), epichlorohydrin rubber (CO), and polysulfide rubber (T). By using a rubber binder, flexibility can be imparted to the entire electromagnetic wave absorber, and it becomes easy to conform to the surface shape of the electronic device to which the electromagnetic wave absorber is to be attached.

When the same type of binder is used for the electromagnetic wave absorption layer and the electromagnetic wave reflection suppression layer, the layers can be brought into areal contact without using an adhesive layer between the two layers. On the other hand, a layer having another function may also be formed between the electromagnetic wave absorption layer and the electromagnetic wave reflection suppression layer. As an example, a flame retardant layer having a flame retardant function may also be formed. In this case, the same binder as that is included in the electromagnetic wave absorption layer and the electromagnetic wave reflection suppression layer can contain a phosphorus-containing compound as a flame retardant. The content of the flame retardant in the flame retardant layer is preferably 5 to 20 parts by mass with respect to 100 parts by mass of the binder.

In order to improve the strength of the electromagnetic wave absorber, silicone rubber (Q) and fluororubber (FKM) are particularly preferable among the above-mentioned rubber binders. As the silicone rubber, any of an addition reaction type, a condensation reaction type, and a peroxide-curable type can be used. However, peroxide-curable silicone rubber is preferable because the crosslink density can be controlled and any hardness can be obtained.

The first binder included in the electromagnetic wave reflection suppression layer and the second binder included in the electromagnetic wave absorption layer may be the same as or different from each other. Also, each binder may be a mixture of a plurality of types of binders.

However, the content ratio of the first binder in the electromagnetic wave reflection suppression layer needs to be 85 mass% or more, and the content ratio of the first binder needs to be greater than the content ratio of the second binder in the electromagnetic wave absorption layer. Also, the electromagnetic wave reflection suppression layer may be formed using only the first binder. As a result, reflection of electromagnetic waves on the surface of the electromagnetic wave absorber can be suppressed and the reflection attenuation amount can be increased, and therefore the electromagnetic wave reflection suppression layer can be provided with an electromagnetic wave reflection suppression function. On the other hand, the content ratio of the second binder in the electromagnetic wave absorption layer is preferably 15 to 55 mass%.

The first binder in the electromagnetic wave reflection suppression layer is mainly used as a matrix material when forming the electromagnetic wave reflection suppression layer. Also, the second binder in the electromagnetic wave absorption layer disperses and fixes the above-mentioned electromagnetic wave absorbing material and is used as a matrix material when forming the electromagnetic wave absorption layer.

When the electromagnetic wave reflection suppression layer and the electromagnetic wave absorption layer of the present application are laminated, it is possible to suppress reflection of the electromagnetic waves incident from the electromagnetic wave reflection suppression layer side on the surface of the electromagnetic wave reflection suppression layer since the permittivity of the electromagnetic wave reflection suppression layer is lower than the permittivity of the electromagnetic wave absorption layer, and therefore the reflection attenuation amount can be increased, the transmission attenuation amount can also be increased, and the electromagnetic wave absorption ability can be improved.

<Others>

The electromagnetic wave absorption layer preferably contains carbon particles such as carbon black particles in order to improve the electromagnetic wave absorption characteristics. Also, it is preferable to add a dispersant to the electromagnetic wave absorption layer in order to uniformly arrange the electromagnetic wave absorbing material without uneven distribution.

Next, properties of the electromagnetic wave absorber of this embodiment will be described.

<Electromagnetic Wave Reflection Attenuation Amount and Electromagnetic Wave Transmission Attenuation Amount>

The electromagnetic wave reflection attenuation amount of the electromagnetic wave absorber of this embodiment is preferably -10 dB or less and the electromagnetic wave transmission attenuation amount of the electromagnetic wave absorber of this embodiment is preferably -10 dB or less, in the frequency band of 76 to 81 GHz. The above-mentioned attenuation amount being -10 dB or less means that 10% or less of incident electromagnetic waves are reflected or transmitted.

The electromagnetic wave reflection attenuation amount and the electromagnetic wave transmission attenuation amount of the electromagnetic wave absorber of this embodiment can be measured using the free space method shown in later-described Examples.

<Thicknesses of Electromagnetic Wave Absorption Layer and Electromagnetic Wave Reflection Suppression Layer>

In the electromagnetic wave absorber of this embodiment, a ratio (A/B) between a thickness A (mm) of the electromagnetic wave absorption layer and a thickness B (mm) of the electromagnetic wave reflection suppression layer is preferably 0.7 to 1.4. Within this range, it is possible in some cases to reduce the electromagnetic wave reflection attenuation amount to -15 dB or less. The above-mentioned attenuation amount being -15 dB or less means that 3.16% or less of an incident electromagnetic wave is reflected. On the other hand, if (A/B) is smaller than 0.7, the thickness A of the electromagnetic wave absorption layer is small, and therefore the electromagnetic wave transmission amount cannot be sufficiently reduced. Also, when (A/B) is larger than 1.4, the thickness B of the electromagnetic wave reflection suppression layer is small, and therefore the electromagnetic wave reflection amount cannot be sufficiently reduced. (A/B) is more preferably 0.9 to 1.4.

Also, the electromagnetic wave absorption layer preferably has a thickness of 1 to 2 mm. Within this range, the strength and flexibility of the electromagnetic wave absorber can be maintained at a practical level.

The thicknesses of the electromagnetic wave absorption layer and the electromagnetic wave reflection suppression layer of the electromagnetic wave absorber of this embodiment can be measured as follows. That is, an image of a cross section of a sample that has been cut by cutter knife cutting, ion milling, and the like such that the cross section of the electromagnetic wave absorber is vertical is captured in a range in which the entire thickness of the sample can be observed using a microscope (e.g., "VHX-6000" manufactured by Keyence Corporation) at 20-fold magnification. Next, the length of a layer at five points randomly selected from the captured image is measured using analysis software of the microscope. Furthermore, the same process is implemented on 3 randomly selected visual fields, and the average of the thicknesses of the layer at the 15 points is calculated. This is performed for each of the electromagnetic wave absorption layer and the electromagnetic wave reflection suppression layer.

<Real Part of Relative Permittivity at 1 GHz of Electromagnetic Wave Absorption Layer and Electromagnetic Wave Reflection Suppression Layer>

A ratio (C/D) between a real part C of the relative permittivity at 1 GHz of the electromagnetic wave absorption layer and a real part D of the relative permittivity at 1 GHz of the electromagnetic wave reflection suppression layer, which are measured in accordance with the definition of JIS C 2138-2007, is preferably 1.5 to 11.6. This is because within this range, the difference between the relative permittivity of the air layer and the relative permittivity of the electromagnetic wave reflection suppression layer can be made small. (C/D) is more preferably 3.0 to 11.0.

Also, the real part C of the relative permittivity at 1 GHz of the electromagnetic wave absorption layer is preferably 5 to 40. If the real part C of the relative permittivity at 1 GHz of the electromagnetic wave absorption layer is less than 5 or more than 40, the composite impedance when combined with the electromagnetic wave reflection suppression layer will deviate from the impedance of air, and the electromagnetic wave reflection amount of the electromagnetic wave absorber will increase.

<Hardnesses of Electromagnetic Wave Reflection Suppression Layer and Electromagnetic Wave Absorption Layer>

The hardnesses of the electromagnetic wave reflection suppression layer and the electromagnetic wave absorption layer of the electromagnetic wave absorber of this embodiment are preferably 40 to 80, and more preferably 50 to 70 in terms of durometer type A hardness defined in JIS K 6253-1997. As a result, the durability of the electromagnetic wave absorber can be improved.

<Adhesion Strength between Electromagnetic Wave Absorption Layer and Electromagnetic Wave Reflection Suppression Layer>

If the electromagnetic wave absorption layer and the electromagnetic wave reflection suppression layer of the electromagnetic wave absorber of this embodiment are in contact with each other, the adhesive force between the electromagnetic wave absorption layer and the electromagnetic wave reflection suppression layer is preferably 6 N/10 mm or more in terms of 180° peel strength defined in JIS Z 0237-2009.

<Breaking Elongation of Entire Electromagnetic Wave Absorber>

The breaking elongation of the entire electromagnetic wave absorber of this embodiment is preferably 150% or more. The breaking elongation of the entire electromagnetic wave absorber can be measured as follows. That is, a test piece is prepared by punching out the entire electromagnetic wave absorber with a dumbbell-shaped No. 3, and it is pulled at a tensile speed of $500\pm50$ mm/min at a temperature of $23\pm2$°C.
The elongation when the specimen is broken is thereby recorded. Next, the elongation at break Eb (%) is calculated using the following formula.

$$Eb=(L-L_0)/L_0$$

where L: length at break, and $L_0$: initial length.

Examples

Hereinafter, the present application will be described in detail based on examples. However, the present application is not limited to the following examples.

(Example 1)

<Production of Electromagnetic Wave Absorbing Sheet>

After kneading the components of the electromagnetic wave absorption layer shown below in a kneader, the kneaded product was separated through a calender molding method, and then, after kneading the components of the electromagnetic wave reflection suppression layer shown below in a kneader, the kneaded product was separated through a calender molding method, and the electromagnetic wave reflection suppression layer was laminated on the electromagnetic wave absorption layer separated previously. Next, the laminated electromagnetic wave absorption layer and electromagnetic wave reflection suppression layer were cut into a sheet with a width of 1000 mm after a crosslinking step at a crosslinking temperature of 190°C and a secondary vulcanization step at 200°C, and the sheet was wound onto a roll to produce the laminated electromagnetic wave absorbing sheet of Example 1. The thickness of the electromagnetic wave absorption layer of the laminated electromagnetic wave absorbing sheet that was produced was 2.0 mm, and the thickness of the electromagnetic wave reflection suppression layer was 1.4 mm.

[Components of Electromagnetic Wave Absorption Layer]

(1) Silicone rubber (product name "KE-951KU" manufactured by Shin-Etsu Chemical Co., Ltd., silica particle content: 10 mass%): 33.0 mass%
(2) Magnetoplumbite-type strontium ferrite (magnetic resonance frequency: 76.5 GHz): 64.5 mass%
(3) Carbon black (product name "Lionite CB" manufactured by Lion Specialty Chemicals Co., Ltd.): 1.5 mass%
(4) Processing aid (product name "Lunac S-50V" manufactured by Kao Corporation): 0.3 mass%

(5) Processing aid (product name "Plastrogin S" manufactured by Fuso Chemical Industry Co., Ltd.): 0.5 mass%
(6) Crosslinking agent (product name "C-8A" manufactured by Shin-Etsu Chemical Co., Ltd.): 0.2 mass%

[Components of Electromagnetic Wave Reflection Suppression Layer]

(1) Silicone rubber (product name "KE-951KU" manufactured by Shin-Etsu Chemical Co., Ltd., silica particle content: 10 mass%): 99.0 mass%
(2) Crosslinking agent (product name "C-8A" manufactured by Shin-Etsu Chemical Co., Ltd.): 1.0 mass%

(Example 2)

A laminated electromagnetic wave absorbing sheet of Example 2 was produced in the same manner as in Example 1, except that the thickness of the electromagnetic wave absorption layer was 1.7 mm, and the thickness of the electromagnetic wave reflection suppression layer was 1.7 mm.

(Example 3)

A laminated electromagnetic wave absorbing sheet of Example 3 was produced in the same manner as in Example 1, except that the thickness of the electromagnetic wave absorption layer was 1.0 mm, and the thickness of the electromagnetic wave reflection suppression layer was 1.5 mm.

(Example 4)

A laminated electromagnetic wave absorbing sheet of Example 4 was produced in the same manner as in Example 1, except that the following components of the electromagnetic wave absorption layer were used, the thickness of the electromagnetic wave absorption layer was 1.7 mm, and the thickness of the electromagnetic wave reflection suppression layer was 1.7 mm.

[Components of Electromagnetic Wave Absorption Layer]

(1) Silicone rubber (product name "KE-951KU" manufactured by Shin-Etsu Chemical Co., Ltd., silica particle content: 10 mass%): 52.3 mass%
(2) Magnetoplumbite-type strontium ferrite (magnetic resonance frequency: 76.5 GHz): 45.0 mass%
(3) Carbon black (product name "Lionite CB" manufactured by Lion Specialty Chemicals Co., Ltd.): 1.1 mass%
(4) Processing aid (product name "Lunac S-50V" manufactured by Kao Corporation): 0.4 mass%
(5) Processing aid (product name "Plastrogin S" manufactured by Fuso Chemical Industry Co., Ltd.): 0.8 mass%
(6) Crosslinking agent (product name "C-8A" manufactured by Shin-Etsu Chemical Co., Ltd.): 0.4 mass%

(Example 5)

A laminated electromagnetic wave absorbing sheet of Example 5 was produced in the same manner as in Example 1, except that the following components of the electromagnetic wave absorption layer were used, the thickness of the electromagnetic wave absorption layer was 1.7 mm, and the thickness of the electromagnetic wave reflection suppression layer was 1.7 mm.

[Components of Electromagnetic Wave Absorption Layer]

(1) Silicone rubber (product name "KE-951KU" manufactured by Shin-Etsu Chemical Co., Ltd., silica particle content: 10 mass%): 12.9 mass%
(2) Magnetoplumbite-type strontium ferrite (magnetic resonance frequency: 76.5 GHz): 85.0 mass%
(3) Carbon black (product name "Lionite CB" manufactured by Lion Specialty Chemicals Co., Ltd.): 1.7 mass%
(4) Processing aid (product name "Lunac S-50V" manufactured by Kao Corporation): 0.1 mass%

(5) Processing aid (product name "Plastrogin S" manufactured by Fuso Chemical Industry Co., Ltd.): 0.2 mass%
(6) Crosslinking agent (product name "C-8A" manufactured by Shin-Etsu Chemical Co., Ltd.): 0.1 mass%

(Example 6)

A laminated electromagnetic wave absorbing sheet of Example 6 was produced in the same manner as in Example 1, except that the following components of the electromagnetic wave absorption layer were used, the thickness of the electromagnetic wave absorption layer was 1.7 mm, and the thickness of the electromagnetic wave reflection suppression layer was 1.7 mm.

[Components of Electromagnetic Wave Absorption Layer]

(1) Silicone rubber (product name "KE-951KU" manufactured by Shin-Etsu Chemical Co., Ltd., silica particle content: 10 mass%): 14.6 mass%
(2) Magnetoplumbite-type strontium ferrite (magnetic resonance frequency: 76.5 GHz): 85.0 mass%
(3) Carbon black (product name "Lionite CB" manufactured by Lion Specialty Chemicals Co., Ltd.): 0 mass%
(4) Processing aid (product name "Lunac S-50V" manufactured by Kao Corporation): 0.1 mass%
(5) Processing aid (product name "Plastrogin S" manufactured by Fuso Chemical Industry Co., Ltd.): 0.2 mass%
(6) Crosslinking agent (product name "C-8A" manufactured by Shin-Etsu Chemical Co., Ltd.): 0.1 mass%

(Example 7)

A laminated electromagnetic wave absorbing sheet of Example 7 was produced in the same manner as in Example 1, except that the following components of the electromagnetic wave reflection suppression layer were used, the thickness of the electromagnetic wave absorption layer was 1.7 mm, and the thickness of the electromagnetic wave reflection suppression layer was 1.7 mm.

[Components of Electromagnetic Wave Reflection Suppression Layer]

(1) Silicone rubber (product name "KE-951KU" manufactured by Shin-Etsu Chemical Co., Ltd., silica particle content: 10 mass%): 85.0 mass%
(2) Crosslinking agent (product name "C-8A" manufactured by Shin-Etsu Chemical Co., Ltd.): 1.0 mass%
(3) Non-magnetic particles (talc: hydrated magnesium silicate, product name "FS205" manufactured by Fuji Talc Industries Co., Ltd.): 14.0 mass%

(Example 8)

A laminated electromagnetic wave absorbing sheet of Example 8 was produced in the same manner as in Example 1, except that the following components of the electromagnetic wave reflection suppression layer were used, the thickness of the electromagnetic wave absorption layer was 1.7 mm, and the thickness of the electromagnetic wave reflection suppression layer was 2.0 mm.

[Components of Electromagnetic Wave Reflection Suppression Layer]

(1) Nylon resin (product name "10 13B" manufactured by Ube Industries, Ltd.): 100.0 mass%

(Comparative Example 1)

An electromagnetic wave absorption layer with a thickness of 1.7 mm was produced using the following components of the electromagnetic wave absorption layer, and an electromagnetic wave absorbing sheet with a thickness of 1.7 mm consisting only of the electromagnetic wave absorption layer of Comparative Example 1 was produced by using only the produced electromagnetic wave absorption layer as it is.

[Components of Electromagnetic Wave Absorption Layer]

(1) Silicone rubber (product name "KE-951KU" manufactured by Shin-Etsu Chemical Co., Ltd., silica particle content: 10 mass%): 10.7 mass%
(2) Magnetoplumbite-type strontium ferrite (magnetic resonance frequency: 76.5 GHz): 87.2 mass%
(3) Carbon black (product name "Lionite CB" manufactured by Lion Specialty Chemicals Co., Ltd.): 1.7 mass%
(4) Processing aid (product name "Lunac S-50V" manufactured by Kao Corporation): 0.1 mass%
(5) Processing aid (product name "Plastrogin S" manufactured by Fuso Chemical Industry Co., Ltd.): 0.2 mass%
(6) Crosslinking agent (product name "C-8A" manufactured by Shin-Etsu Chemical Co., Ltd.): 0.1 mass%

(Comparative Example 2)

A laminated electromagnetic wave absorbing sheet of Comparative Example 2 was produced in the same manner as in Example 1, except that the following components of the electromagnetic wave absorption layer were used, the thickness of the electromagnetic wave absorption layer was 1.7 mm, and the thickness of the electromagnetic wave reflection suppression layer was 1.7 mm.

[Components of Electromagnetic Wave Absorption Layer]

(1) Silicone rubber (product name "KE-951KU" manufactured by Shin-Etsu Chemical Co., Ltd., silica particle content: 10 mass%): 10.7 mass%
(2) Magnetoplumbite-type strontium ferrite (magnetic resonance frequency: 76.5 GHz): 87.2 mass%
(3) Carbon black (product name "Lionite CB" manufactured by Lion Specialty Chemicals Co., Ltd.): 1.7 mass%
(4) Processing aid (product name "Lunac S-50V" manufactured by Kao Corporation): 0.1 mass%
(5) Processing aid (product name "Plastrogin S" manufactured by Fuso Chemical Industry Co., Ltd.): 0.2 mass%
(6) Crosslinking agent (product name "C-8A" manufactured by Shin-Etsu Chemical Co., Ltd.): 0.1 mass%

(Comparative Example 3)

A laminated electromagnetic wave absorbing sheet of Comparative Example 3 was produced in the same manner as in Example 1, except that the following components of the electromagnetic wave absorption layer were used, the thickness of the electromagnetic wave absorption layer was 1.7 mm, and the thickness of the electromagnetic wave reflection suppression layer was 1.7 mm.

[Components of Electromagnetic Wave Absorption Layer]

(1) Silicone rubber (product name "KE-951KU" manufactured by Shin-Etsu Chemical Co., Ltd., silica particle content: 10 mass%): 55.4 mass%
(2) Magnetoplumbite-type strontium ferrite (magnetic resonance frequency: 76.5 GHz): 42.0 mass%
(3) Carbon black (product name "Lionite CB" manufactured by Lion Specialty Chemicals Co., Ltd.): 1.0 mass%
(4) Processing aid (product name "Lunac S-50V" manufactured by Kao Corporation): 0.4 mass%
(5) Processing aid (product name "Plastrogin S" manufactured by Fuso Chemical Industry Co., Ltd.): 0.8 mass%
(6) Crosslinking agent (product name "C-8A" manufactured by Shin-Etsu Chemical Co., Ltd.): 0.4 mass%

(Comparative Example 4)

A laminated electromagnetic wave absorbing sheet of Comparative Example 4 was produced in the same manner as in Example 1, except that the following components of the electromagnetic wave reflection suppression layer were used, the thickness of the electromagnetic wave absorption layer was 2.0 mm, and the thickness of the electromagnetic wave reflection suppression layer was 1.4 mm.

[Components of Electromagnetic Wave Reflection Suppression Layer]

(1) Silicone rubber (product name "KE-951KU" manufactured by Shin-Etsu Chemical Co., Ltd., silica particle content: 10 mass%): 80.0 mass%
(2) Crosslinking agent (product name "C-8A" manufactured by Shin-Etsu Chemical Co., Ltd.): 1.0 mass%
(3) Non-magnetic particles (talc: hydrated magnesium silicate, product name "FS205" manufactured by Fuji Talc Industries Co., Ltd.): 19.0 mass %

(Comparative Example 5)

A laminated electromagnetic wave absorbing sheet of Comparative Example 5 was produced in the same manner as in Example 1, except that the following components of the electromagnetic wave reflection suppression layer were used, the thickness of the electromagnetic wave absorption layer was 1.0 mm, and the thickness of the electromagnetic wave reflection suppression layer was 0.05 mm.

[Components of Electromagnetic Wave Reflection Suppression Layer]

(1) Silicone rubber (product name "KE-951KU" manufactured by Shin-Etsu Chemical Co., Ltd., silica particle content: 10 mass%): 49.6 mass%
(2) Crosslinking agent (product name "C-8A" manufactured by Shin-Etsu Chemical Co., Ltd.): 0.4 mass%
(3) Non-magnetic particles (aluminum oxide: product name "AS-10" manufactured by Showa Denko): 50.0 mass%

Next, the following properties of the electromagnetic wave absorbing sheets produced in Examples 1 to 8 and Comparative Examples 1 to 5 were measured.

<Electromagnetic Wave Reflection Attenuation Amount and Electromagnetic Wave Transmission Attenuation Amount>

The electromagnetic wave reflection attenuation amount and the electromagnetic wave transmission attenuation amount were measured using the free space method. Specifically, as shown in FIG. 2, a millimeter wave network analyzer "ME7838A" (product name) 20 manufactured by Anritsu Corporation was used to emit input waves (millimeter waves) 25 with a frequency of 76.5 GHz from an antenna 21 connected to a first port 20a to an electromagnetic wave reflection suppression layer side of an electromagnetic wave absorbing sheet 24 via a dielectric lens 23, and electromagnetic waves 26 reflected on the electromagnetic wave reflection suppression layer were measured by the antenna 21 arranged on the electromagnetic wave reflection suppression layer side of the electromagnetic wave absorbing sheet 24. Also, electromagnetic waves 27 transmitted through the electromagnetic wave absorbing sheet 24 were measured by an antenna 22 that is arranged on an electromagnetic wave absorption layer side of the electromagnetic wave absorbing sheet 24 and connected to a second port 20b. The intensity of the emitted electromagnetic waves 25, and the intensities of the reflected electromagnetic waves 26 and the transmitted electromagnetic waves 27 were respectively determined as power values, and the electromagnetic wave reflection attenuation amount and the electromagnetic wave transmission attenuation amount were determined in units of dB from the difference in intensity.

<Real Part of Relative Permittivity at 1 GHz>

The real part C of the relative permittivity at 1 GHz of the electromagnetic wave absorption layers and the real part D of the relative permittivity at 1 GHz of the electromagnetic wave reflection suppression layers were measured in accordance with the definition of JIS C 2138-2007. Also, based on the result, a ratio (C/D) between the real part C of the relative permittivity at 1 GHz and the real part D of the relative permittivity at 1 GHz was determined.

<Breaking Elongation of Electromagnetic Wave Absorbing Sheet>

The breaking elongations of the entire electromagnetic wave absorbing sheets were measured using the method described above.
The above results are shown in Tables 1 and 2. Table 1 also shows the thicknesses A of the electromagnetic wave absorption layers, the thicknesses B of the electromagnetic wave reflection suppression layers, and the ratios A/B thereof.

Table 1

| | Reflection attenuation amount (dB) | Transmission attenuation amount (dB) | Absorption layer thickness A (mm) | Suppression layer thickness B (mm) | A/B |
|---|---|---|---|---|---|
| Example 1 | -10.6 | -18.0 | 2.0 | 1.4 | 1.4 |
| Example 2 | -21.7 | -15.7 | 1.7 | 1.7 | 1.0 |
| Example 3 | -10.8 | -10.3 | 1.0 | 1.5 | 0.7 |
| Example 4 | -10.7 | -11.5 | 1.7 | 1.7 | 1.0 |
| Example 5 | -12.2 | -25.0 | 1.7 | 1.7 | 1.0 |
| Example 6 | -18.1 | -20.4 | 1.7 | 1.7 | 1.0 |
| Example 7 | -20.0 | -15.2 | 1.7 | 1.7 | 1.0 |
| Example 8 | -10.9 | -15.6 | 1.7 | 2.0 | 0.9 |
| Comp. Ex. 1 | -7.2 | -15.3 | 1.7 | - | - |
| Comp. Ex. 2 | -9.6 | -25.6 | 1.7 | 1.7 | 1.0 |
| Comp. Ex. 3 | -9.8 | -9.2 | 1.7 | 1.7 | 1.0 |
| Comp. Ex. 4 | -7.9 | -17.7 | 2.0 | 1.4 | 1.4 |
| Comp. Ex. 5 | -4.4 | -10.2 | 1.0 | 0.05 | 20.0 |

Table 2

| | Real part C of relative permittivity at 1 GHz of absorption layer | Real part D of relative permittivity at 1 GHz of suppression layer | C/D | Breaking elongation (%) |
|---|---|---|---|---|
| Example 1 | 12.9 | 3.4 | 3.8 | 270 |
| Example 2 | 13.1 | 3.4 | 3.9 | 300 |
| Example 3 | 13.3 | 3.4 | 3.9 | 290 |
| Example 4 | 6.9 | 3.4 | 2.0 | 350 |
| Example 5 | 33.4 | 3.4 | 9.8 | 160 |

(continued)

|  | Real part C of relative permittivity at 1 GHz of absorption layer | Real part D of relative permittivity at 1 GHz of suppression layer | C/D | Breaking elongation (%) |
|---|---|---|---|---|
| Example 6 | 15.2 | 3.4 | 4.5 | 190 |
| Example 7 | 13.1 | 2.8 | 4.7 | 220 |
| Example 8 | 13.1 | 3.2 | 4.1 | 15 |
| Comp. Ex. 1 | 35.9 | - | - | 300 |
| Comp. Ex. 2 | 35.9 | 3.4 | 10.6 | 80 |
| Comp. Ex. 3 | 6.4 | 3.4 | 1.9 | 330 |
| Comp. Ex. 4 | 13.1 | 2.6 | 5.0 | 260 |
| Comp. Ex. 5 | 12.9 | 4.2 | 3.1 | 260 |

From Table 1, the electromagnetic wave absorbing sheets of Examples 1 to 8 were able to suppress the electromagnetic wave reflection attenuation amount to -10 dB or less. On the other hand, in the electromagnetic wave absorbing sheets of Comparative Examples 1 to 5, the electromagnetic wave reflection attenuation amounts exceeded -10 dB.

Furthermore, in Comparative Example 4, in which the content of the first binder in the electromagnetic wave reflection suppression layer was 80 mass%, which is less than 85 mass%, the -dB value of the reflection attenuation amount at 76.5 GHz was large (the reflection attenuation amount, which is the absolute value of the -dB value, was small). Also, in Comparative Example 5, in which the content of the first binder in the electromagnetic wave reflection suppression layer was 49.6 mass%, which is even lower, the -dB value of the reflection attenuation amount at 76.5 GHz was even larger than that in Comparative Example 4 (the reflection attenuation amount, which is the absolute value of the -dB value, was small). Also, the -dB value of the transmission attenuation amount at 76.5 GHz was larger than that of Comparative Example 4 (the transmission attenuation, which is the absolute value of the -dB value, was small).

<Relationship between Thickness of Each Layer of Electromagnetic Wave Absorbing Sheet and Electromagnetic Wave Reflection Attenuation Amount>

The thickness of the electromagnetic wave absorption layer of the electromagnetic wave absorbing sheet of Example 1 was changed to 1.40 mm, 1.55 mm, 1.60 mm, 1.80 mm, and 2.00 mm, the thickness of the electromagnetic wave reflection suppression layer was changed to 1.20 mm, 1.30 mm, 1.40 mm, 1.50 mm, 1.60 mm, 1.65 mm, 1.70 mm, 1.75 mm, 1.80 mm, 1.90 mm, 1.95 mm, and 2.00 mm, these were combined to produce electromagnetic wave absorbing sheets, and the electromagnetic wave reflection attenuation amount of each sheet was measured in the same manner as in Example 1. As a result, the electromagnetic wave reflection attenuation amount was reduced to -6 dB or less for all combinations of electromagnetic wave absorbing sheets. In particular, among the electromagnetic wave absorbing sheets mentioned above, in electromagnetic wave absorbing sheets in which the ratio (A/B) between the thickness A (mm) of the electromagnetic wave absorption layer and the thickness B (mm) of the electromagnetic wave reflection suppression layer is 0.7 to 1.4, all of the electromagnetic wave reflection attenuation amounts were reduced to -10 dB or less.

The present application can be implemented in forms other than those described above. The embodiments disclosed in this application are merely examples, and the present invention is not limited thereto. The scope of this application is to be interpreted with priority given to the description of the accompanying claims rather than the description of the above specification, and all changes within the range of equivalence to the claims are included within the scope of the claims.

Industrial Applicability

The electromagnetic wave absorber of the present application can provide an electromagnetic wave absorber capable of absorbing electromagnetic waves in a high frequency band higher than or equal to the millimeter wave band and capable of suppressing reflection of electromagnetic waves, and is useful for producing electronic components and electronic devices with excellent EMC.

Description of Reference Numerals

| 10 | Electromagnetic wave absorber |
| 11 | Electromagnetic wave absorption layer |
| 12 | Electromagnetic wave reflection suppression layer |
| 13 | Electromagnetic wave |
| 20 | Millimeter-wave network analyzer |
| 20a | First port |
| 20b | Second port |
| 21,22 | Antenna |
| 23 | Dielectric lens |
| 24 | Electromagnetic wave absorbing sheet |
| 25 | Input electromagnetic wave |
| 26 | Reflected electromagnetic wave |
| 27 | Transmitted electromagnetic wave |

**Claims**

1. An electromagnetic wave absorber comprising an electromagnetic wave reflection suppression layer and an electromagnetic wave absorption layer,

   wherein the electromagnetic wave reflection suppression layer contains a first binder,
   a content ratio of the first binder in the electromagnetic wave reflection suppression layer is 85 mass% or more,
   the electromagnetic wave absorption layer contains a second binder and an electromagnetic wave absorbing material, and
   a content ratio of the electromagnetic wave absorbing material in the electromagnetic wave absorption layer is 45 to 85 mass%.

2. The electromagnetic wave absorber according to claim 1, wherein the electromagnetic wave absorbing material contains a magnetic iron oxide that has magnetic resonance in a frequency band higher than or equal to the millimeter wave band.

3. The electromagnetic wave absorber according to claim 1 or 2, wherein the electromagnetic wave reflection suppression layer further contains non-magnetic particles.

4. The electromagnetic wave absorber according to any one of claims 1 to 3, wherein the first binder and the second binder include at least one type of rubber binder selected from the group consisting of natural rubber (NR), isoprene rubber (IR), butadiene rubber (BR), styrene-butadiene rubber (SBR), butyl rubber (IIR), nitrile rubber (NBR), ethylene-propylene rubber (EPDM), chloroprene rubber (CR), acrylic rubber (ACM), chlorosulfonated polyethylene rubber (CSR), urethane rubber (PUR), silicone rubber (Q), fluororubber (FKM), ethylene-vinyl acetate rubber (EVA), epichlorohydrin rubber (CO), and polysulfide rubber (T).

5. The electromagnetic wave absorber according to any one of claims 1 to 4, further comprising an adhesive layer between the electromagnetic wave reflection suppression layer and the electromagnetic wave absorption layer.

6. The electromagnetic wave absorber according to any one of claims 1 to 5, wherein in a frequency band of 76 to 81 GHz, an electromagnetic wave reflection attenuation amount is -10 dB or less, and an electromagnetic wave transmission attenuation amount is -10 dB or less.

7.  The electromagnetic wave absorber according to any one of claims 1 to 6, wherein a ratio (A/B) between a thickness A (mm) of the electromagnetic wave absorption layer and a thickness B (mm) of the electromagnetic wave reflection suppression layer is 0.7 to 1.4.

8.  The electromagnetic wave absorber according to any one of claims 1 to 7, wherein the electromagnetic wave absorption layer has a thickness of 1 to 2 mm.

9.  The electromagnetic wave absorber according to any one of claims 1 to 8, wherein a ratio (C/D) between a real part C of a relative permittivity at 1 GHz of the electromagnetic wave absorption layer and a real part D of a relative permittivity at 1 GHz of the electromagnetic wave reflection suppression layer, which is measured in accordance with the definition of JIS C 2138-2007, is 1.5 to 11.6.

10. The electromagnetic wave absorber according to any one of claims 1 to 9, wherein a real part C of a relative permittivity at 1 GHz of the electromagnetic wave absorption layer is 5 to 40.

11. The electromagnetic wave absorber according to any one of claims 1 to 10, wherein a hardness of the electromagnetic wave reflection suppression layer and the electromagnetic wave absorption layer is 40 to 80 in terms of durometer type A hardness defined in JIS K 6253-1997.

12. The electromagnetic wave absorber according to any one of claims 1 to 11,

    wherein the electromagnetic wave absorption layer and the electromagnetic wave reflection suppression layer are in contact with each other, and
    an adhesive strength between the electromagnetic wave absorption layer and the electromagnetic wave reflection suppression layer is 6 N/10 mm or more in terms of 180° peel strength defined in JIS Z 0237-2009.

13. The electromagnetic wave absorber according to any one of claims 1 to 12, wherein a breaking elongation of the entire electromagnetic wave absorber is 150% or more.

14. The electromagnetic wave absorber according to any one of claims 1 to 13, further comprising a sticky layer on the electromagnetic wave absorption layer side.

FIG. 1

FIG. 2

<table>
<tr><td colspan="2">**INTERNATIONAL SEARCH REPORT**</td><td>International application No.<br><br>**PCT/JP2022/034435**</td></tr>
</table>

**A. CLASSIFICATION OF SUBJECT MATTER**

*H05K 9/00*(2006.01)i; *B32B 7/025*(2019.01)i; *B32B 25/00*(2006.01)i; *B32B 27/18*(2006.01)i; *C08L 101/00*(2006.01)i; *H01B 3/00*(2006.01)i; *H01F 1/113*(2006.01)i
FI: H05K9/00 M; H01F1/113; C08L101/00; H01B3/00 C; B32B7/025; B32B27/18 Z; B32B25/00; H05K9/00 W

According to International Patent Classification (IPC) or to both national classification and IPC

**B. FIELDS SEARCHED**

Minimum documentation searched (classification system followed by classification symbols)

H05K9/00; B32B7/025; B32B25/00; B32B27/18; C08L101/00; H01B3/00; H01F1/113

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2020-145340 A (FUJIFILM CORP.) 10 September 2020 (2020-09-10)<br>paragraphs [0013]-[00149], fig. 1 | 1, 2, 4, 6, 9-14 |
| Y | | 1-14 |
| Y | JP 2009-188322 A (NEW INDUSTRY RESEARCH ORGANIZATION) 20 August 2009 (2009-08-20)<br>paragraphs [0054]-[0065], [0082] | 1-14 |
| Y | WO 2018/168859 A1 (MAXELL HOLDINGS LTD.) 20 September 2018 (2018-09-20)<br>paragraph [0082] | 3, 5 |
| Y | WO 2018/124131 A1 (KANSAI PAINT CO., LTD.) 05 July 2018 (2018-07-05)<br>paragraph [0076] | 5 |
| A | JP 63-155700 A (TORAY INDUSTRIES, INC.) 28 June 1988 (1988-06-28) | 1-14 |

☐ Further documents are listed in the continuation of Box C.    ☑ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **24 November 2022** | **06 December 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

INTERNATIONAL SEARCH REPORT
Information on patent family members

| Patent document cited in search report | | | Publication date (day/month/year) | Patent family member(s) | | | Publication date (day/month/year) |
|---|---|---|---|---|---|---|---|
| JP | 2020-145340 | A | 10 September 2020 | (Family: none) | | | |
| JP | 2009-188322 | A | 20 August 2009 | (Family: none) | | | |
| WO | 2018/168859 | A1 | 20 September 2018 | US | 2020/0008328 | A1 | |
| | | | | paragraph [0098] | | | |
| | | | | EP | 3598862 | A1 | |
| | | | | CN | 110235537 | A | |
| | | | | CN | 113727594 | A | |
| WO | 2018/124131 | A1 | 05 July 2018 | (Family: none) | | | |
| JP | 63-155700 | A | 28 June 1988 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007081119 A
- JP 5481613 B
- JP 2008060484 A
- JP 4787978 B
- JP 2008277726 A
- JP 4859791 B
- JP 2007250823 A
- JP 4674380 B
- JP 2000031686 A
- JP 2003133783 A
- JP 2009188322 A